# EUROPEAN PATENT APPLICATION

(11) **EP 3 706 312 A1**
(43) Date of publication of application: **09.09.2020**
(21) Application number: 19160790.2
(22) Date of filing: 05.03.2019
(51) Int. Cl.: H03F 1/32, H03F 3/195, H03F 3/21, H03F 3/24, H03F 3/45

(54) **A RADIO FREQUENCY POWER AMPLIFIER SYSTEM**

(71) Applicant: Aquilto AB, 174 46 Sundbyberg (SE)
(72) Inventor: Carlsson, Mats, 174 46 SUNDBYBERG (SE); Omid, Najari, 113 60 STOCKHOLM (SE)
(74) Representative: AWA Sweden AB

(57) **Abstract**

The present invention provides a radio frequency power amplifier system (100) including a main power amplifier (101), having an input (107) and an output (108), a secondary power amplifier (102), having an input (109) and an output (110), an internal load (103) connected to the output of the secondary power amplifier, and a feedback network (104) having an input end connected to the output of the secondary power amplifier, and an output end connected to the input of the secondary power amplifier. The main power amplifier is a scaled up replica of the secondary power amplifier. The inputs of the main and secondary power amplifiers are interconnected at a common input node (113), and the power amplifier system has an input port (114) connected to the common input node.

## Description

### FIELD OF THE INVENTION

The present invention relates to the field of radio frequency power amplifier systems.

### BACKGROUND OF THE INVENTION

It is well known that the output signal from a radio frequency (RF) power amplifier (PA) can be linearized by various techniques, such as pre-distortion, feed-forward error correction, and feedback. These techniques are well described in both text books as well as in various scientific and white papers, e.g. the white paper entitled Linearizing High Power Amplifiers, by Allen Katz, Linear Technology Inc. The high-level issues with these techniques are summarized below.

Pre-distortion can be implemented either as analog or digital pre-distortion. In both ways, the behavior of the PA is characterized, and its response is compensated for by deliberately distorting the signal that drives the PA. If the applied distortion on the input signal is carefully selected, the output signal from the PA could become more linear. However, initial calibration and training is often required, and pre-distortion systems are often sensitive to drift, for instance drift in temperature.

One common feedback method is to use so called Cartesian feedback. In a Cartesian feedback system, the response from the PA is down-converted and compared with the base-band IQ signals. This approach eliminates issues with drift and detailed characterization of the transfer function of the PA. A main drawback with a Cartesian feedback system is stability problems and a limited bandwidth that it can handle while still maintaining a stable operation. Cartesian feedback is therefore not suitable for systems where the signal bandwidth is increased to hundreds of MHz, e.g. the wireless communication standard 802.11ac where the largest bandwidth is 160MHz. Cartesian feedback is also adding circuit complexity and power dissipation.

Another feedback method is to use a linear feedback network from the PA output to its input. This method gives superior performance but is very difficult to get stable for all different load conditions.

### SUMMARY OF THE INVENTION

It would be advantageous to reduce the instability of the feedback methods.

To address this issue, in a first aspect of the invention there is presented a radio frequency power amplifier system comprising a main power amplifier, having an input and an output, a secondary power amplifier, having an input and an output, an internal load connected to the output of the secondary power amplifier, and a feedback network having an input end connected to the output of the secondary power amplifier, and an output end connected to the input of the secondary power amplifier. The main power amplifier is a scaled up replica of the secondary power amplifier. The inputs of the main and secondary power amplifiers are interconnected at a common input node. The power amplifier system has an input port connected to the common input node. Thereby, the feedback path is not connected directly to the output of the main power amplifier, and thus to an external load, but to an internal load, which makes it possible to stabilize the feedback path since the internal load is known. The input current will flow into the secondary PA, which is linearized due to the feedback. Since the main PA is a replica of the secondary PA and since it is connected in parallel with the devices in the secondary PA, the currents in the main PA will be replicas of the currents in the secondary PA. Since the main PA is larger, the signal in the main PA will be a larger copy of the signal in the secondary PA. Thereby, the main PA is linearized as well.

In accordance with an embodiment of the power amplifier system, the input port is connected to the common input node via a subtractor, and the output end of the feedback network is connected to the common input node via the subtractor.

In accordance with an embodiment of the power amplifier system, the secondary power amplifier comprises first and second transistors connected in series, wherein the first transistor provides the input of the secondary power amplifier, and wherein the second transistor provides the output of the secondary power amplifier. This provides for a substantial similarity of the current of the main PA relative to the current of the secondary PA.

In accordance with an embodiment of the power amplifier system, the internal load comprises a parallel resonant circuit including the parallel combination of an inductor, a capacitance and a resistor.

In accordance with an embodiment of the power amplifier system, the internal load is resonant at operation frequencies of the radio frequency power amplifier system. This is advantageous in that it provides the highest possible loop gain of the feedback loop.

In accordance with an embodiment of the power amplifier system, the main power amplifier provides a differential output signal, wherein the power amplifier system comprises a transformer at an output port thereof, which transformer is arranged to transform the differential output signal of the main power amplifier to a single ended output signal of the power amplifier system, and wherein the transformer and the internal load have been arranged to have the same frequency response. This is advantageous as regards the matching between the secondary PA and the main PA.

### BRIEF DESCRIPTION OF THE DRAWINGS

The invention will now be described in more detail and with reference to the appended drawings in which:

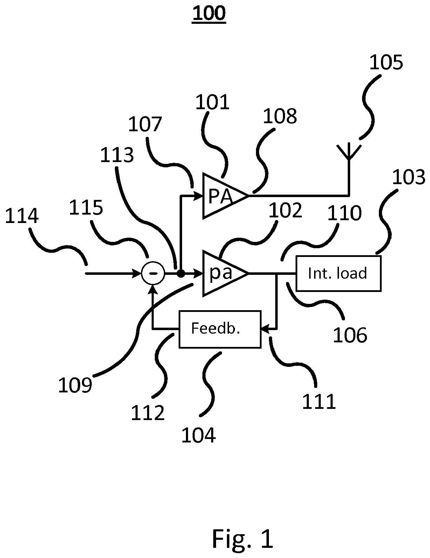

Fig. 1 is a block diagram of an embodiment of a radio frequency PA system according to the present invention; and
Fig. 2 is an example circuit diagram of the radio frequency PA system of Fig. 1, and
Fig. 3 is a graph showing the response at the output of the PA system within an exemplifying frequency range.

### DESCRIPTION OF EMBODIMENTS

An embodiment of the radio frequency power amplifier (PA) system 100 comprises a main PA 101, having an input 107 and an output 108, a secondary PA 102, having an input 109 and an output 110, an internal load 103 connected to the output 110 of the secondary PA, and a feedback network 104 having an input end 111 connected to the output 110 of the secondary PA 102, and an output end 112 connected to the input 109 of the secondary PA 102. The inputs 107, 109 of the main and secondary power amplifiers 101, 102 are interconnected at a common input node 113. The power amplifier system 100 has an input port 114 connected to the common input node 113. The power amplifier system 100 is connected to an external load 105, which can be any suitable device, such as an antenna, a filter, an external PA, etc.

More particularly, the input port 114 of the power amplifier system 100 and the output 112 of the feedback network 104 are connected to a subtractor 115, which in turn is connected to the common input node 113. The subtractor 115 does not have to be a separate physical circuit, but it can be a connection node to which the feedback signal is fed in such a state that it is subtracted from the input signal to the power amplifier system 100.

Preferably, the main PA 101 constitutes a scaled replica of the secondary PA 102, and vice versa. In many applications the scaling factor between the main and secondary PAs 101, 102 ranges from about 2:1, up to about 8:1, but other relations can be provided as well. In order to be clear about what the scaling means, it defines the relation between the gain between the input signal and the output signal of the main PA 101 and the corresponding gain of the secondary PA 102. Thus, for instance, with a scaling factor of 4:1 the gain of the primary PA 101 is a factor 4 times the gain of the secondary PA 102, which corresponds to 12 dB. In addition, the non-linearities in the secondary PA 102 are suppressed due to the feedback network 104. Since the main PA 101 is a scaled version of the secondary PA 102, it will respond in the same way to the input signal 113 as the secondary PA 102, resulting in suppressed non-linearities also in the main PA 101.

The power amplifier system 100 operates as follows. The main PA 101 drives the external load 105 without any feedback signal. The secondary PA 102 is implemented in a similar way as the main PA 101, i.e. the two PA:s provide a similar response to input signals. Since the feedback network 104 is connected around the secondary PA 102, the feedback network 104 linearizes the secondary PA 102 and makes the output signal at its output 106 less distorted. The operation of the feedback network 104 around the secondary PA 102 can be made stable since the internal load 103 is known and not accessible from the outside. By driving the main PA 101 with an input signal constituting the result of the feedback signal, output from the feedback network 104, subtracted from the input signal to the power amplifier system 100, the input signal to the main PA 101 will be modified in such way that the distortion of the main PA 101 is compensated for.

Hence, in contrast to the prior art feedback systems mentioned above, which are possible to get stable for some load conditions, it is possible to get the present PA system 100 stable for all or a substantial part of all load conditions. This is, generally, because in the prior art feedback systems the PA output as well as the input of the feedback network are connected to the input port of the external load, and the load conditions of that input port will vary and are therefore not known.

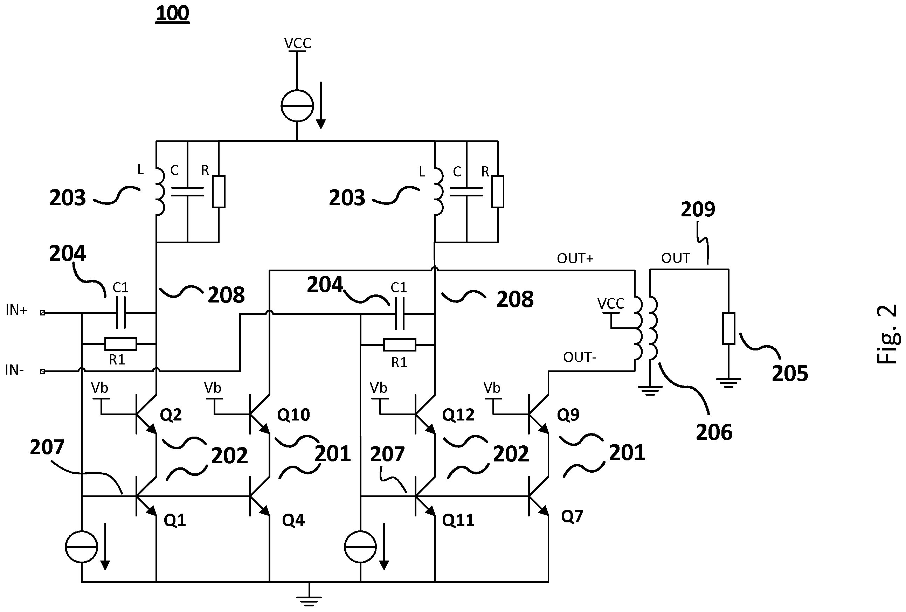

On a circuit diagram level, one possible implementation of the embodiment of the PA system 100 described above is as shown in Fig. 2. The PA system 100 consists of two equal halves which are driven by a differential input signal connected to the respective inputs IN+ and IN- of the halves. The main PA 201 comprises four transistors Q4, Q7, Q9 and Q10, i.e. two for each half, which are connected in pairs with two transistors Q4, Q10 and Q7, Q9, respectively, connected in series in each pair. The secondary PA 202 comprises four transistors Q1, Q2, Q11 and Q12 as well, connected in a similar way as the transistors of the main PA 201, i.e. two for each half, which are connected in pairs with two transistors Q1, Q2 and Q11, Q12, respectively, connected in series in each pair. The internal load 203 comprises two identical networks of well-controlled internal components, where each network is connected to a respective one of the transistor pairs Q1, Q2 and Q11, Q12 of the secondary PA 202. For instance, the internal load 203 comprises, and here contains, a resistor R, a capacitor C and an inductance L connected in parallel, as shown in Fig. 2, but many possible combinations of components are of course feasible. The internal feedback network 204 comprises a parallel connection of a resistor R1 and a capacitor C1 for each transistor pair Q1, Q2 and Q11, Q12 of the secondary PA 202.

More particularly, referring to one of the halves, the transistors Q1, Q2 of the secondary PA 202 are connected as follows. A first transistor Q1 thereof has its emitter connected to ground, and its base connected to the input port IN+ of the PA system 100. A second transistor Q2 thereof has its emitter connected to the collector of the first transistor Q1, its base connected to a constant base voltage Vb, and its collector connected to the internal load 203, i.e. embodying the output 110 of the secondary PA 202. Consequently, the feedback network 204, consisting of the resistor R1 and the capacitor C1, is connected between the collector of the second transistor Q2 and the base of the first transistor Q1. At a typical frequency of operation, e.g. in the interval 4.8 GHz- 6 GHz, the feedback network 204 can be considered as a short circuit from the output 208 of the secondary PA 202 to its input 207.

The differential output signal from the main PA 201, i.e. the output signals OUT+, OUT- of the respective half, is converted, at the output port 209 of the PA system 100, to a single ended output signal OUT by means of a transformer 206, which drives the external load 205, which here is single ended. This kind of transformer is also known as a balun.

The internal load 203, i.e. the parallel connection of the inductor L, capacitor C and resistor R, has been arranged to have the same frequency response as the balun, which is advantageous from a matching point of view between the replica PA and the main PA. Furthermore, it is advantageous if the inductor L and capacitance C of the internal load 203 is resonant at the frequency of operation of the PA system 100, since this gives the highest possible loop gain of the feedback loop. Typically, the internal load 203 is then a parallel resonant circuit, where the parallel resistor R is an equivalent resistor originating from the losses in the parallel resonance circuit. The capacitance C in the resonance circuit typically originates from the combination of all parasitic capacitances from the output 208 of the secondary PA 202.

The linearization technique of the present PA system provides the same improvements as the prior art negative feedback PA system, but with eliminated, or at least substantially reduced, stability problems. Further, it is more robust and less sensitive for drift compared to other known linearization techniques. In addition, it is suitable for chip-integration, both in CMOS and Bipolar technologies. It would be obvious to the person skilled in the art how to implement the PA system in CMOS technology instead of the bipolar technology shown in the exemplifying drawings. Thus, according to embodiments of the PA system, it is integrated on a single chip.

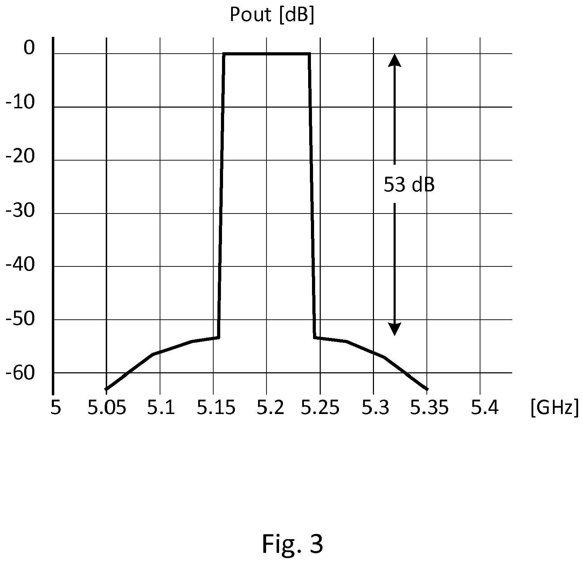

According to an example the linearity performance of the PA implementation as shown in Fig. 2 was simulated with an 80 MHz 802.11ac input signal, where the modulation of the 256 sub-carriers was emulated with a continuous wave signal with random phase. The response at the output of the PA system 100 is shown in Fig. 3 for a power level of +20dBm, resulting in an EVM (Error Vector Magnitude) of -53dB.

While the invention has been illustrated and described in detail in the drawings and foregoing description, such illustration and description are to be considered illustrative or exemplary and not restrictive. The invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. Any reference signs in the claims should not be construed as limiting the scope.

## Claims

1. A radio frequency power amplifier system comprising a main power amplifier (101), having an input (107) and an output (108), a secondary power amplifier (102), having an input (109) and an output (110), an internal load (103) connected to the output of the secondary power amplifier, and a feedback network (104) having an input end (111) connected to the output of the secondary power amplifier, and an output end (112) connected to the input of the secondary power amplifier, wherein the main power amplifier is a scaled up replica of the secondary power amplifier, wherein the inputs of the main and secondary power amplifiers are interconnected at a common input node (113), and wherein the power amplifier system has an input port (114) connected to the common input node.

2. The radio frequency power amplifier system according to claim 1, wherein the input port (114) is connected to the common input node (113) via a subtractor (115), and wherein the output end (112) of the feedback network (104) is connected to the common input node via the subtractor.

3. The radio frequency power amplifier system according to claim 1 or 2, wherein the secondary power amplifier (102) comprises first and second transistors (Q1, Q2) connected in series, wherein the first transistor (Q1) provides the input of the secondary power amplifier, and wherein the second transistor (Q2) provides the output of the secondary power amplifier.

4. The radio frequency power amplifier system according to any one of the preceding claims, wherein the feedback network (104) provides a short circuit from the output (110) of the secondary power amplifier (102) to the input (109) of the secondary power amplifier.

5. The radio frequency power amplifier system according to any one of the preceding claims, wherein the internal load (103) comprises a parallel resonant circuit including the parallel combination of an inductor, a capacitance and a resistor.

6. The radio frequency power amplifier system according to claim 5, wherein the internal load is resonant at operation frequencies of the power amplifier system.

7. The radio frequency power amplifier system according to claim 5 or 6, wherein the main power amplifier (201) provides a differential output signal (OUT+, OUT-), wherein the power amplifier system (100) comprises a transformer (206) at an output port (209) thereof, which transformer is arranged to transform the differential output signal of the main power amplifier to a single ended output signal (OUT) of the power amplifier system, and wherein the transformer and the internal load have been arranged to have the same frequency response.
